# EUROPÄISCHE PATENTSCHRIFT

(11) **EP 2 715 826 B1**
(45) Veröffentlichungstag und Bekanntmachung des Hinweises auf die Patenterteilung: **05.08.2020**
(21) Anmeldenummer: 12721247.0
(22) Anmeldetag: 09.05.2012
(51) Int. Cl.: H01L 51/52

(54) **ORGANISCHES ELEKTROLUMINESZIERENDES BAUELEMENT**
ORGANIC ELECTROLUMINESCENT COMPONENT
COMPOSANT ÉLECTROLUMINESCENT ORGANIQUE

(30) Priorität: 31.05.2011 DE 102011076791
(43) Veröffentlichungstag der Anmeldung: 09.04.2014
(73) Patentinhaber: OSRAM OLED GmbH, 93049 Regensburg (DE)
(72) Erfinder: DIEZ, Carola, 93049 Regensburg (DE); SETZ, Daniel Steffen, 71034 Böblingen (DE)
(74) Vertreter: Epping - Hermann - Fischer
(86) Internationale Anmeldenummer: PCT/EP2012/058501
(87) Internationale Veröffentlichungsnummer: WO 2012/163637

(56) Entgegenhaltungen:
- WO-A1-2009/104148
- US-A1- 2005 173 700
- US-A1- 2006 240 278
- US-A1- 2009 140 645

## Beschreibung

Es wird ein organisches elektrolumineszierendes Bauelement angegeben.

Es sind organische Licht emittierende Dioden (OLED) bekannt, die im Betrieb einseitig emittierend sind. Dabei ist eine Seite der OLED reflektierend ausgebildet, während die andere Seite, durch die Licht abgestrahlt wird, transparent ist.

Weiterhin sind OLEDs bekannt, die im Betrieb beidseitig emittierend sind und im ausgeschalteten Zustand transparent sind. Das in einem elektrolumineszierenden Bereich erzeugte Licht wird dabei üblicherweise gleichmäßig in Richtung beider Seiten abgestrahlt, so dass die Emissionseigenschaften auf den beiden Seiten nicht unabhängig voneinander eingestellt werden können.

Um eine OLED herzustellen, die auf beiden Seiten voneinander getrennt einstellbare Emissionseigenschaften aufweist, werden üblicherweise zwei einseitig emittierende OLEDs mit ihren reflektierenden Seiten aneinander angeordnet und unabhängig voneinander betrieben.

Die Druckschrift US 2005/0173700 A1 beschreibt einen elektrolumineszierenden (EL) Schichtenstapel eines Subpixels eines organischen Vollfarbdisplays mit zwei EL-Einheiten zwischen zwei Elektroden, wobei zwischen den EL-Einheiten eine Zwischenschicht, beispielsweise eine metallische Zwischenschicht, angeordnet ist. Die Zwischenschicht soll eine Verbesserung der Elektronen- und Lochinjektion in die angrenzenden EL-Einheiten bewirken, wobei die Transparenz des Schichtenstapels durch die Zwischenschicht nicht herabgesetzt werden soll, da eine Lichtabstrahlung von beiden EL-Einheiten beispielsweise durch ein Substrat auf einer Seite des Schichtenstapels erfolgen soll, so dass die Zwischenschicht möglichst transparent sein soll.

Auch die Druckschriften US 2006/0240278 A1 und US 2009/0140645 A1 beschreiben gestapelte organische elektrolumineszierende Bauelemente mit einer oder mehreren metallischen Zwischenschichten, die ebenfalls möglichst transparent ausgebildet sein sollen. In WO 2009/104148 wird eine beidseitig emittierende OLED offenbart, die eine mittlere, kontaktierbare Elektrode aufweist.

Zumindest einigen Ausführungsformen liegt die Aufgabe zugrunde, ein organisches elektrolumineszierendes Bauelement anzugeben.

Diese Aufgabe wird durch einen Gegenstand mit Merkmalen gemäß der folgenden Beschreibung gelöst. Vorteilhafte Ausführungsformen und Weiterbildungen des Gegenstands sind in den Ansprüchen gekennzeichnet und gehen weiterhin aus der nachfolgenden Beschreibung und den Zeichnungen hervor.

Gemäß zumindest einer Ausführungsform weist ein organisches elektrolumineszierendes Bauelement zumindest einen ersten und einen zweiten organischen Funktionsstapel auf. Der zumindest eine erste und zweite organische Funktionsstapel kann insbesondere zwischen einer ersten Elektrode und einer zweiten Elektrode angeordnet sein, über die elektrische Ladungsträger, also Elektronen und Löcher, in den zumindest einen ersten und zweiten organischen Funktionsstapel injiziert werden können. Weiterhin kann der zumindest eine erste oder zweite organische Funktionsstapel auf einem Substrat angeordnet sein. Der zumindest eine erste oder zweite organische Funktionsstapel kann insbesondere zumindest eine und besonders bevorzugt mehrere organische funktionelle Schichten aufweisen. Diese können organische Polymere, organische Oligomere, organische Monomere, organische kleine nicht-polymere Moleküle ("small molecules") oder Kombinationen daraus aufweisen oder daraus sein.

Gemäß einer weiteren Ausführungsform ist das organische elektrolumineszierende Bauelement als organische Licht emittierende Diode (OLED) ausgebildet. Hierzu weist der zumindest eine erste und zweite organische Funktionsstapel zumindest eine elektrolumineszierende Schicht in Form einer einzelnen Schicht oder in Form eines elektrolumineszierenden Schichtenstapels mit mehreren elektrolumineszierenden Schichten auf, in der Elektronen und Löcher unter Erzeugung von Licht rekombinieren können. Als Licht kann hier und im Folgenden insbesondere elektromagnetische Strahlung in einem ultravioletten bis infraroten Spektralbereich und insbesondere in einem sichtbaren Spektralbereich bezeichnet sein.

Als Materialien für die zumindest eine oder die mehreren elektrolumineszierenden Schichten eignen sich insbesondere Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Alternativ oder zusätzlich können die zumindest eine oder die mehreren elektrolumineszierenden Schichten auch Small-Molecule-Materialien aufweisen, die mittels Fluoreszenz oder Phosphoreszenz Licht erzeugen können.

Erfindungsgemäß weist der zumindest eine organische Funktionsstapel zumindest eine dotierte Schicht auf. Die dotierte Schicht kann hierbei durch eine p-dotierte oder durch eine n-dotierte Schicht gebildet werden. Als p-dotierte bzw. n-dotierte Schichten werden Schichten bezeichnet, die zur Leitung von Löchern bzw. Elektronen geeignet sind und beispielsweise im Falle einer p-dotierten organischen Schicht Löcher von einer Anode zu zumindest einer elektrolumineszierenden organischen Schicht und im Falle einer n-dotierten Schicht Elektronen von einer Kathode zu zumindest einer elektrolumineszierenden organischen Schicht leiten können. Die organischen funktionellen Schichten des zumindest einen organischen Funktionsstapels und insbesondere die p-dotierten bzw. n-dotierten Schichten können beispielsweise Ladungsträgertransportschichten, also Elektronentransportschichten und/oder Lochtransportschichten, Ladungsträgerblockierschichten, also Elektronenblockierschichten und/oder Lochblockierschichten, und/oder Ladungsträgerinjektionsschichten, also Elektroneninjektionsschichten und/oder Lochinjektionsschichten, aufweisen oder durch eine oder mehrere solcher Schichten gebildet sein. Organische Materialien für derartige funktionelle Schichten sind dem Fachmann bekannt und werden daher hier nicht weiter ausgeführt.

Erfindungsgemäß weist der zumindest eine erste und zweite organische Funktionsstapel zumindest eine elektrolumineszierende organische Schicht sowie zumindest eine dotierte organische Schicht, also zumindest eine n-dotierte organische Schicht und/oder zumindest eine p-dotierte organische Schicht, auf. Besonders bevorzugt kann der zumindest eine organische Funktionsstapel zumindest eine elektrolumineszierende organische Schicht aufweisen, die zwischen zumindest einer n-dotierten und zumindest einer p-dotierten organischen Schicht angeordnet ist.

Gemäß einer weiteren Ausführungsform weist das organische elektrolumineszierende Bauelement ein Substrat auf, das als Platte oder Folie ausgebildet ist und eine oder mehrere Schichten aufweist, die Glas, Quarz, Kunststoff, Metall oder eine Kombination daraus aufweisen oder daraus sind. Ist das organisch elektrolumineszierende Bauelement als ein so genannter "Bottom-Emitter" ausgeführt, d. h. dass im zumindest einen organischen Funktionsstapel erzeugtes Licht durch das Substrat abgestrahlt wird, so kann das Substrat eine Transparenz für zumindest einen Teil des Lichts aufweisen. In diesem Fall kann das Substrat bevorzugt Glas oder einen transparenten Kunststoff aufweisen oder daraus sein.

Erfindungsgemäß sind die erste und zweite Elektroden transparent für zumindest einen Teil des im zumindest einen organischen Funktionsstapel erzeugten Lichts. Eine transparente Elektrode kann beispielsweise ein transparentes leitendes Oxid aufweisen oder aus einem transparenten leitenden Oxid bestehen. Transparente leitende Oxide (transparent conductive oxides, "TCO") sind transparente, leitende Materialien, in der Regel Metalloxide wie beispielsweise Zinkoxid, Zinnoxid, Cadmiumoxid, Titanoxid, Indiumoxid, ,Indiumzinkoxid (IZO) oder Indiumzinnoxid (ITO). Neben binären Metallsauerstoffverbindungen, wie beispielsweise Titanoxid, ZnO, SnO₂ oder In₂O₃ gehören auch ternäre Metallsauerstoffverbindungen, wie beispielsweise AlZnO, Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Gemäß einer weiteren Ausführungsform kann zumindest eine der ersten und zweiten Elektrode ein Metall aufweisen oder daraus sein. Beispielsweise kann das Metall ausgewählt sein aus Aluminium, Barium, Indium, Silber, Gold, Magnesium, Kalzium, Lithium sowie Verbindungen, Kombinationen und Legierungen daraus. Eine Elektrode, die ein Metall aufweist oder daraus ist, weist eine ausreichend geringe Dicke auf, sodass das Metall zumindest teilweise transparent ist. Weiterhin kann eine Elektrode auch zumindest eine Schicht aus einem TCO und zumindest eine Schicht aus einem, bevorzugt transparenten, Metall aufweisen. Weiterhin kann zumindest eine Elektrode zumindest zwei Schichten aus einem TCO aufweisen, zwischen denen zumindest eine transparente Metallschicht angeordnet ist. In weiteren Ausführungsformen kann die erste und/oder die zweite Elektrode eines oder mehrere der folgenden Materialien alternativ oder zusätzlich zu den genannten Materialien aufweisen: Netzwerke aus metallischen Nanodrähten und/oder - teilchen, beispielsweise aus Ag; Netzwerke aus Kohlenstoff-Nanoröhrchen; Graphen-Teilchen oder -Schichten; Netzwerke aus halbleitenden Nanodrähten. Ferner können diese Elektroden leitfähige Polymere oder Übergangsmetalloxide oder leitfähige transparente Oxide aufweisen.

Zumindest eine der ersten und zweiten Elektrode ist als Anode ausgeführt, während die andere der ersten und zweiten Elektrode als Kathode ausgeführt ist.

Erfindungsgemäß weist das organische elektrolumineszierende Bauelement zumindest zwei organische Funktionsstapel auf. Das kann insbesondere bedeuten, dass das organische elektrolumineszierende Bauelement einen ersten organischen Funktionsstapel aufweist, auf dem ein zweiter organischer Funktionsstapel angeordnet ist. Die zumindest zwei organischen Funktionsstapel können dabei jeweils Merkmale gemäß den vorgenannten Ausführungsformen aufweisen. Insbesondere können die zumindest zwei organischen Funktionsstapel zwischen einer ersten und einer zweiten Elektrode angeordnet sein, sodass der erste organische Funktionsstapel und der darauf angeordnete zweite organische Funktionsstapel zwischen der ersten und zweiten Elektrode in Serie hintereinander geschaltet sind.

Erfindungsgemäß weist das organische elektrolumineszierende Bauelement zumindest zwei organische Funktionsstapel auf, von denen ein erster organischer Funktionsstapel zumindest eine erste elektrolumineszierende Schicht und zumindest eine n-dotierte organische Schicht aufweist, während ein zweiter organischer Funktionsstapel zumindest eine zweite elektrolumineszierende Schicht und zumindest eine p-dotierte organische Schicht aufweist. Darüber hinaus können der erste und der zweite organische Funktionsstapel noch weitere vorab genannte funktionelle Schichten aufweisen. Der erste und der zweite organische Funktionsstapel sind derart aufeinander angeordnet, dass die n-dotierte organische Schicht des ersten organischen Funktionsstapels und die p-dotierte organische Schicht des zweiten organischen Funktionsstapels einander zugewandt sind und zwischen der ersten und der zweiten elektrolumineszierenden Schicht angeordnet sind.

Erfindungsgemäß weist das organische elektrolumineszierende Bauelement zwischen dem ersten und dem zweiten organischen Funktionsstapel eine Metallschicht auf. Die Metallschicht wird zwischen der n-dotierten organischen Schicht des ersten organischen Funktionsstapels und der p-dotierten organischen Schicht des zweiten organischen Funktionsstapels unmittelbar an diese angrenzend zwischen den beiden organischen Funktionsstapeln angeordnet sein. Eine solche Kombination von benachbarten n- und p-dotierten organischen Schichten mit einer dazwischen angeordneten Metallschicht kann eine ladungserzeugende Schichtfolge oder Einheit ("charge generation layer", CGL; "charge generation unit", CGU) bilden. Durch eine derartige ladungserzeugende Schichtfolge können zueinander benachbarte organische Funktionsstapel elektrisch miteinander verbunden werden, wobei durch die ladungserzeugende Schichtfolge in die benachbarten organischen Funktionsstapel Ladungsträger injiziert werden können. Es hat sich gezeigt, dass insbesondere durch die Ausbildung von einer ladungserzeugenden Schicht mit einer Metallschicht eine hohe Spannungsstabilität und damit eine hohe Lebensdauer des organischen elektrolumineszierenden Bauelements erreicht werden kann. Durch das Anordnen der Metallschicht in der ladungserzeugenden Schicht kann eine Verringerung der notwendigen Betriebsspannung erreicht werden, da das Metall als zusätzliches Ladungsträgerreservoir dient und somit die Injektion von Ladungsträgern in benachbarte organische Funktionsstapel erleichtert. Des Weiteren können durch die Metallschicht ungewollte chemische Reaktionen zwischen der n- und der p-dotierten Schicht vermieden werden, die zu einer zusätzlichen Barriere und somit zum Spannungsanstieg führen würden.

Gemäß einer weiteren Ausführungsform weist das organische elektrolumineszierende Bauelement zumindest drei organische Funktionsstapel auf, wobei von jeweils direkt zueinander benachbarten organischen Funktionsstapeln einer eine p-dotierte und einer eine n-dotierte organische Schicht aufweist, die zwischen den jeweiligen elektrolumineszierenden Schichten der beiden Funktionsstapel angeordnet sind und zwischen denen unmittelbar angrenzend eine Metallschicht angeordnet ist.

Durch ein Übereinanderstapeln von zumindest zwei organischen Funktionsstapeln oder zumindest drei organischen Funktionsstapeln mit dazwischen angeordneten Metallschichten können bei praktisch gleicher Effizienz und identischer Leuchtdichte deutlich längere Lebensdauern gegenüber einfachen OLEDs mit nur einer elektrolumineszierenden Schicht oder einem elektrolumineszierenden Schichtenstapel zwischen n-dotierten und p-dotierten Schichten zwischen den Elektroden erreicht werden. Durch die n-dotierten und p-dotierten organischen Schichten und die Metallschicht werden zwischen den organischen Funktionsstapeln jeweils ladungserzeugende Schichten gebildet, die eine effiziente Ladungsträgerinjektion in die organischen Funktionsstapel ermöglichen und so auch bei einer Stapelung von zumindest zwei oder zumindest drei organischen Funktionsstapeln zu einer niedrigen Stromdichte und einer hohen Spannungsstabilität führen. Die Betriebsspannung skaliert dabei linear mit der Anzahl der organischen Funktionsstapel. Gemäß einer weiteren Ausführungsform können die erste elektrolumineszierende Schicht und die zweite elektrolumineszierende Schicht Licht mit der gleichen oder mit unterschiedlichen Wellenlängen abstrahlen. Dadurch kann, abhängig von der Ausbildung der Metallschicht sowie der Elektroden gemäß den folgenden Ausführungsbeispielen an einer oder an beiden Seiten des organischen elektrolumineszierenden Bauelements gleiches oder verschiedenfarbiges ein- oder mischfarbiges Licht abgestrahlt werden.

Erfindungsgemäß ist die Metallschicht potentialfrei ("floating"). Das bedeutet, dass die Metallschicht über keinen Anschluss und keine Kontaktmöglichkeit nach außen, beispielsweise an eine externe Strom- und/oder Spannungsquelle, verfügt und nicht an ein externes elektrisches Potential angelegt wird oder werden kann. Insbesondere ist die Metallschicht demzufolge nicht kontaktierbar. Vielmehr handelt es sich bei der Metallschicht um eine zwischen dem ersten und dem zweiten organischen Funktionsstapel angeordnete Schicht, die, wie oben beschrieben, der Ladungsträgerinjektion zusammen mit den direkt angrenzenden p-dotierten und n-dotierten Schichten und damit einer seriellen Verschaltung des ersten und des zweiten organischen Funktionsstapels dient. Weiterhin ist die Metallschicht gemäß einer weiteren Ausführungsform nicht als Substrat ausgebildet und kann insbesondere nicht als Substrat eines oder beider organischer Funktionsstapel dienen. Das kann beispielsweise bedeuten, dass die Metallschicht eine Dicke aufweist, die nicht ausreichend ist, um eine ausreichende Tragfestigkeit und Stabilität zu gewährleisten, die erforderlich wäre, um als Substrat zu dienen.

Gemäß einer weiteren Ausführungsform weist die Metallschicht Aluminium und/oder Silber auf oder besteht daraus. Metalle wie Aluminium und Silber weisen eine hohe elektrische Leitfähigkeit sowie abhängig von der Dicke der Metallschicht beispielsweise für Licht im sichtbaren Spektralbereich eine hohe Reflektivität auf.

Gemäß einer Ausführungsform die nicht zur Erfindung gehört, ist die Metallschicht zumindest teilweise transparent. Das kann insbesondere bedeuten, dass Licht, das im ersten organischen Funktionsstapel durch die erste elektrolumineszierende Schicht erzeugt wird, zumindest teilweise durch die Metallschicht hindurchgestrahlt werden kann und beispielsweise weiterhin auch durch den zweiten organischen Funktionsstapel hindurchgestrahlt werden kann. Umgekehrt kann bei einer zumindest teilweise transparenten Metallschicht Licht aus dem zweiten organischen Funktionsstapel und insbesondere aus der zweiten elektrolumineszierenden Schicht durch die Metallschicht in und weiterhin auch beispielsweise durch den ersten organischen Funktionsstapel gestrahlt werden. Die Metallschicht kann dafür bevorzugt eine Dicke von kleiner oder gleich 10 nm aufweisen, insbesondere im Falle einer Metallschicht, die Aluminium und/oder Silber aufweist oder daraus ist.

Erfindungsgemäß sind die erste und die zweite Elektrode, zwischen denen der erste und der zweite organische Funktionsstapel und die Metallschicht angeordnet sind, transparent.

Erfindungsgemäß ist die Metallschicht nicht-transparent. Insbesondere ist die Metallschicht dabei reflektierend ausgebildet, sodass Licht, das in der ersten elektrolumineszierenden Schicht erzeugt wird und in Richtung der Metallschicht abgestrahlt wird, von dieser zurückreflektiert wird. Ebenso kann durch die nicht-transparente und bevorzugt reflektierende Metallschicht Licht, das in der zweiten elektrolumineszierenden Schicht gebildet wird, von der Metallschicht reflektiert werden.

Erfindungsgemäß sind dabei die erste und die zweite Elektrode, zwischen denen der erste und der zweite organische Funktionsstapel und die Metallschicht angeordnet sind, transparent. Durch die nicht-transparente und bevorzugt reflektierende Metallschicht zwischen dem ersten und dem zweiten Funktionsstapel können die Leuchteindrücke auf den beiden Seiten des organischen elektrolumineszierenden Bauelements, also auf der Substratseite und der dem Substrat gegenüberliegenden Seite, getrennt voneinander eingestellt werden. Jedoch ist es hierzu nicht erforderlich, die zwei organischen Funktionsstapel getrennt voneinander zu betreiben. Vielmehr ist es aufgrund der durch die n-dotierten und p-dotierten organischen Schichten der organischen Funktionsstapel und aufgrund der Metallschicht zwischen diesen möglich, die beiden organischen Funktionsstapel in Serie zu betreiben. In einem ausgeschalteten Zustand erscheint das organische elektrolumineszierende Bauelement mit einer nicht-transparenten und bevorzugt reflektierenden Metallschicht nicht transparent und bevorzugt spiegelnd. Gemäß einer weiteren Ausführungsform weist die nicht-transparente Metallschicht eine Dicke von größer oder gleich 20 nm und als Material Aluminium auf. Alternativ dazu kann die nicht-transparente Metallschicht beispielsweise auch Silber mit einer Dicke von größer oder gleich 40 nm und besonders bevorzugt von größer oder gleich 50 nm aufweisen.

Gemäß einer weiteren Ausführungsform weist die Metallschicht eine Dicke von kleiner oder gleich 200 nm auf.

Derartige Dicken in Verbindung mit den genannten Materialien können ausreichend sein, um eine ausreichend hohe Reflektivität und eine Undurchlässigkeit für Licht zu ermöglichen, während der Materialaufwand für die Metallschicht und damit auch der Kostenaufwand gering gehalten werden können.

Gemäß einer weiteren Ausführungsform ist die Metallschicht nicht-transparent ausgebildet und die erste elektrolumineszierende Schicht und die zweite elektrolumineszierende Schichten strahlen Licht mit unterschiedlichen Wellenlängen ab. Beispielsweise kann der erste organische Funktionsstapel durch eine geeignete Auswahl von Materialien in der ersten elektrolumineszierenden Schicht und/oder durch geeignete Mehrschichtkombinationen für die erste elektrolumineszierende Schicht weißes Licht abstrahlen, während die zweite elektrolumineszierende Schicht farbiges Licht, beispielsweise rotes, grünes oder blaues Licht oder Mischungen daraus, abstrahlen kann. Weiterhin ist es auch möglich, dass beide organischen Funktionsstapel weißes Licht mit gleichen oder unterschiedlichen Weißtönen bzw. Farbtemperaturen abstrahlen. Unterschiedliche Abstrahlung von Licht nach beiden Seiten des organischen elektrolumineszierenden Bauelements ist mit Vorteil dadurch möglich, dass die Metallschicht nicht-transparent und bevorzugt reflektierend ist, sodass die jeweilige emittierte Farbe bzw. der jeweils emittierte Leuchteindruck nur durch die Art, Menge und Anordnung der jeweiligen elektrolumineszierenden Schichten der auf den beiden Seiten der Metallschicht angeordneten organischen Funktionsstapel abhängig ist. Ein derartiges organisches elektrolumineszierendes Bauelement kann beispielsweise mit Vorteil als Beleuchtungseinrichtung für eine gleichzeitige direkte und indirekte Beleuchtung eingesetzt werden. Dazu wird von einem der beiden organischen Funktionsstapel Licht, insbesondere weißes Licht, mit einer für eine direkte Beleuchtung gewünschten Farbe und Farbtemperatur erzeugt, während der zweite organische Funktionsstapel Licht erzeugt, das für eine indirekte Beleuchtung gewünscht bzw. geeignet ist. Durch die nicht-transparente Metallschicht zwischen den organischen Funktionsstapeln kann sichergestellt werden, dass das jeweilige Licht getrennt voneinander abgestrahlt werden kann.

Die direkte Beleuchtung kann beispielsweise zur Raumbeleuchtung dienen, während die indirekte Beleuchtung als Decken- oder Wandbeleuchtung dient und dabei beispielsweise eine gewünschte farbige Beleuchtung der Decke bzw. der Wand ermöglicht.

Gemäß einer Ausführungsform die nicht zur Erfindung gehört, ist die Metallschicht teilweise reflektierend ausgebildet. Das kann insbesondere bedeuten, dass die Metallschicht auch teilweise transparent ausgebildet ist. Bei einer derartigen Ausführung der Metallschicht kann diese noch ausreichend dünn sein, um Licht teilweise von einem organischen Funktionsstapel in den anderen organischen Funktionsstapel einstrahlen zu lassen, während jeweils auch ein Teil des in den organischen Funktionsstapeln erzeugten Lichts an der Metallschicht reflektiert wird.

Gemäß einer Ausführungsform die nicht zur Erfindung gehört, sind der erste und der zweite organische Funktionsstapel mit einer dazwischen angeordneten teilweise reflektierenden und teilweise transparenten Metallschicht zwischen einer ersten und einer zweiten Elektrode angeordnet, wobei die erste Elektrode transparent und die zweite Elektrode reflektierend und nicht transparent ist. Die transparente erste Elektrode kann dabei beispielsweise zwischen den organischen Funktionsstapeln und dem Substrat angeordnet sein. Alternativ dazu kann die erste, transparente Elektrode beispielsweise auch vom Substrat aus gesehen über den organischen Funktionsstapeln angeordnet sein. Dadurch ist das organische elektrolumineszierende Bauelement im ersten Fall als "Bottom-Emitter" und im zweiten Fall als "Top-Emitter" ausgebildet.

Durch die reflektierende zweite Elektrode und die teilweise reflektierende Metallschicht, zwischen denen beispielsweise der zweite organische Funktionsstapel angeordnet sein kann, kann eine optische Kavität gebildet werden. Diese optische Kavität ist durch die teilweise reflektierende und teilweise transparente Metallschicht an den ersten organischen Funktionsstapel gekoppelt, was auch als so genannte "coupled micro-cavity" bezeichnet wird. Durch die zweite elektrolumineszierende Schicht in der optischen Kavität kann Licht mit einer optimal auf eine gewünschte Farbe eingestellte Wellenlänge abgestrahlt werden, wodurch beispielsweise der Farbwiedergabeindex des organischen elektrolumineszierenden Bauelements im Vergleich zu bekannten OLEDs deutlich erhöht werden kann. Das in der optischen Kavität erzeugte Licht kann aufgrund der reflektierenden zweiten Elektrode durch die teilweise transparente Metallschicht in den ersten organischen Funktionsstapel, der eine so genannte Hauptkavität bilden kann, zurückgestrahlt werden, sodass durch die erste transparente Elektrode mischfarbiges Licht, bestehend aus dem im ersten organischen Funktionsstapel erzeugten Licht und dem im zweiten organischen Funktionsstapel erzeugten Licht, abgestrahlt werden kann.

Die Ausbildung von optischen Kavitäten ist durch eine geeignete Wahl der Transparenz und Reflektivität der ersten und zweiten Elektrode auch im Falle einer nicht-transparenten Metallschicht sowie im Falle einer sehr dünnen und möglichst hoch-transparenten Metallschicht möglich, wobei im Falle einer nicht-transparenten Metallschicht keine optische Kopplung vorliegt.

Durch das Einbringen der Metallschicht in Form einer transparenten, einer teilweise transparenten und teilweise reflektierenden oder auch einer nicht-transparenten und bevorzugt reflektierenden Metallschicht in die ladungserzeugende Schicht ergibt sich die Möglichkeit, unterschiedliche Emissionseigenschaften des organischen elektrolumineszierenden Bauelements zu erreichen. Dabei kann sowohl eine Abstrahlung in beide Richtungen als auch in eine Richtung des organischen elektrolumineszierenden Bauelements erreicht werden. Zusätzlich zu den dadurch erreichten Freiheiten im Farbdesign des organischen elektrolumineszierenden Bauelements kann durch die Metallschicht eine Verringerung der Betriebsspannung und eine Erhöhung der Spannungsstabilität der organischen Funktionsstapel und damit des organischen elektrolumineszierenden Bauelements erreicht werden.

Gemäß einer weiteren Ausführungsform weist das organische elektrolumineszierende Bauelement eine Verkapselungsschicht auf. Beispielsweise können die zumindest zwei organischen Funktionsstapel oder auch die zumindest drei organischen Funktionsstapel zwischen einem Substrat und einer Verkapselungsschicht angeordnet sein. Das Substrat und die Verkapselungsschicht können zum Schutz der organischen Funktionsstapel und der dazwischen angeordneten Metallschicht oder Metallschichten vor Feuchtigkeit, Sauerstoff und anderen schädigenden Substanzen ausgebildet sein. Weiterhin ist es auch möglich, dass beispielsweise zwischen dem Substrat und den organischen Funktionsstapeln eine weitere Verkapselungsschicht angeordnet ist. Diese kann zum Schutz der organischen Funktionsstapel vor schädigenden Substanzen ausgebildet sein, die beispielsweise durch ein nicht hermetisch dichtes Substrat in das organische elektrolumineszierende Bauelement eindringen könnten.

Gemäß einer weiteren Ausführungsform ist eine Verkapselungsschicht als Dünnfilmverkapselung ausgebildet. Das kann insbesondere bedeuten, dass die Verkapselungsschicht zumindest eine und bevorzugt eine Mehrzahl von abgeschiedenen Schichten aufweist, die jeweils für sich genommen oder zumindest in Kombination miteinander eine ausreichende Dichtigkeit gegenüber schädigenden Substanzen aufweisen. Die Verkapselungsschicht kann hierzu eine oder mehrere Schichten aus einem oder mehreren der folgenden Materialien aufweisen: Aluminiumoxid, Zinkoxid, Zirkoniumoxid, Titanoxid, Hafniumoxid, Tantaloxid, Lanthaniumoxid, Siliziumoxid, Siliziumnitrid, Siliziumoxinitrid, Indiumzinnoxid, Indiumzinkoxid, Aluminium-dotiertes Zinkoxid, sowie Kombinationen, Mischungen und Legierungen daraus. Die Verkapselungsschicht kann beispielsweise durch ein Atomlagenabscheideverfahren aufgebracht werden, mit dem sich hochdichte Schichten aus zumindest einigen der oben genannten Materialien erzeugen lassen. Insbesondere kann die Verkapselungsschicht dabei auch transparent sein, sodass die Abstrahleigenschaften des organischen elektrolumineszierenden Bauelements durch die Verkapselungsschicht nicht oder nur wenig beeinflusst werden.

Gemäß einer weiteren Ausführungsform kann die Verkapselungsschicht eine Glasschicht aufweisen. Die Glasschicht kann beispielsweise als Glasplatte oder Glassubstrat ausgebildet sein, die zusammen mit einem Substrat einen abgeschlossenen Hohlraum bilden kann, in dem die organischen Funktionsstapel, die Elektroden sowie die Metallschicht oder die Metallschichten angeordnet sind. Beispielsweise kann die Glasschicht eine Kavität bzw. Vertiefung aufweisen, die beispielsweise mittels Ätzen herstellbar ist und in der beispielsweise auch ein Material angeordnet sein kann, das schädigende Substanzen physikalisch oder chemisch binden kann. Ein solches Material wird auch als Getter-Material bezeichnet und ist dem Fachmann bekannt.

Gemäß einer weiteren Ausführungsform weist das organische elektrolumineszierende Bauelement auf der dem Substrat abgewandten Seite eine Deckschicht auf. Die Deckschicht kann beispielsweise Glas oder einen Kunststoff aufweisen oder daraus sein.

Gemäß einer weiteren Ausführungsform weist das organische elektrolumineszierende Bauelement zumindest eine transparente erste und/oder zweite Elektrode auf, auf der auf einer der Metallschicht abgewandten Seite ein Lichtauskoppelelement angeordnet ist. Das Lichtauskoppelelement kann beispielsweise in Form einer Schicht oder in Form von einzelnen Elementen oder Partikeln ausgebildet sein, die Licht streuend oder Licht brechend sein können. Beispielsweise kann das Lichtauskoppelelement als Streufolie, als Mikro-Linsen-Array oder als Oberflächenstrukturierung einer zusätzlichen transparenten Schicht oder auch des Substrats, einer Verkapselungsschicht oder einer Deckschicht ausgebildet sein.

Weitere Vorteile und vorteilhafte Ausführungsformen und Weiterbildungen ergeben sich aus den im Folgenden in Verbindung mit den Figuren beschriebenen Ausführungsformen.

Es zeigen:
Figur 1 eine schematische Darstellung eines organischen elektrolumineszierenden Bauelements gemäß einem Ausführungsbeispiel,
Figuren 2 bis 4 schematische Darstellungen von organischen elektrolumineszierenden Bauelementen gemäß einem weiteren Ausführungsbeispiel und alternativen Beispielen, und
Figuren 5A bis 5C eine Teststruktur sowie elektrische Eigenschaften dieser.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie z. B. Schichten, Bauteile, Bauelemente und Bereiche, zur besseren Darstellbarkeit und/oder zum besseren Verständnis übertrieben dick oder groß dimensioniert dargestellt sein.

In Figur 1 ist ein Ausführungsbeispiel für ein organisches elektrolumineszierendes Bauelement gezeigt, das einen ersten organischen Funktionsstapel 1 und einen zweiten organischen Funktionsstapel 2 aufweist. Zwischen den beiden organischen Funktionsstapeln 1 und 2 ist eine Metallschicht 3 angeordnet. Das organische elektrolumineszierende Bauelement weist weiterhin ein Substrat 4 auf, auf dem die organischen Funktionsstapel 1 und 2 sowie die Metallschicht 3 zwischen einer ersten Elektrode 5 und einer zweiten Elektrode 6 zur elektrischen Kontaktierung der Funktionsstapel angeordnet sind. Die Elektroden 5 und 6 und die Schichten der organischen Funktionsstapel 1 und 2 können Materialien wie im allgemeinen Teil beschreiben aufweisen.

Erfindungsgemäß sind die Elektroden 5 und 6 transparent ausgebildet, wobei auch das Substrat 4 transparent ausgebildet ist. Der erste organische Funktionsstapel 1 weist zumindest eine erste elektrolumineszierende Schicht 11 und zumindest eine n-dotierte organische Schicht 12 auf. Der zweite organische Funktionsstapel 2 weist zumindest eine zweite elektrolumineszierende Schicht 21 und zumindest eine p-dotierte organische Schicht 23 auf.

Rein beispielhaft sind im gezeigten Ausführungsbeispiel die erste Elektrode 5 als Anode und die zweite Elektrode 6 als Kathode ausgebildet. Alternativ dazu ist eine umgekehrte Anordnung der ersten und der zweiten Elektrode möglich, wobei in diesem Fall auch die Dotierungen der organischen Funktionsstapel 1 und 2 umgekehrt zum gezeigten Ausführungsbeispiel sind.

Die n-dotierte organische Schicht 12 und die p-dotierte organische Schicht 23 sind zwischen den elektrolumineszierenden Schichten 11 und 21 angeordnet und grenzen jeweils direkt an eine dazwischen liegende Metallschicht 3 an. Wie im allgemeinen Teil beschrieben bilden die n-dotierte und die p-dotierte organische Schicht 12 und 23 zusammen mit der Metallschicht 3 eine ladungserzeugende Schichtfolge 30. Die Metallschicht 3 ist potentialfrei angeordnet und verfügt über keinen eigenen Kontakt zu einer externen Strom- und/oder Spannungsversorgung. Die Metallschicht 3 kann im gezeigten Ausführungsbeispiel Aluminium und/oder Silber aufweisen oder daraus sein.

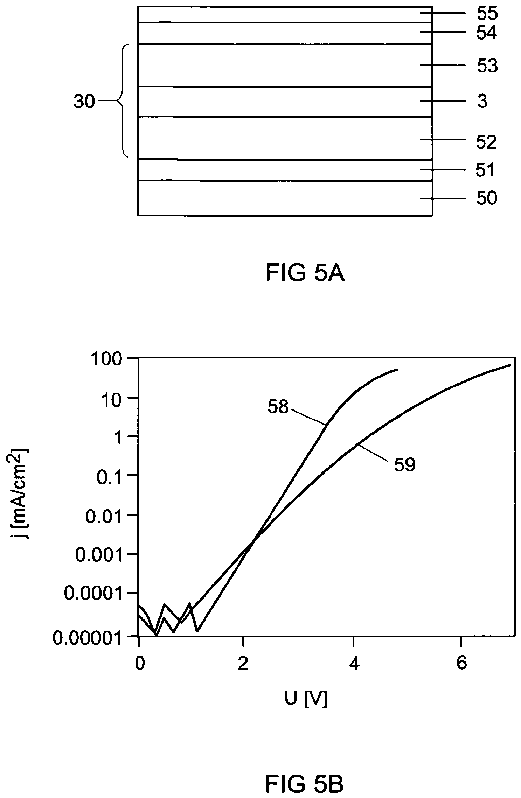

In Verbindung mit den Figuren 5A und 5B ist der Effekt der Metallschicht 3 in einer ladungserzeugenden Schicht 30 gezeigt. Hierzu wurde, wie in Figur 5A gezeigt, eine Teststruktur hergestellt, die auf einem Substrat 50 eine n-dotierte organische Schicht 52, eine Metallschicht 3 und darüber eine p-dotierte organische Schicht 53 als ladungserzeugende Schicht 30 zwischen zwei undotierten organischen Schichten 51 und 54 aufweist. Das Substrat 50 wies in der Teststruktur eine Glasplatte und darauf eine erste Elektrode aus Indium-Zinn-Oxid (ITO) auf. Über den organischen Schichten 51 bis 54 und der Metallschicht 3 ist eine zweite Elektrode 55 aus Metall aufgebracht.

In Figur 5B ist ein Spannung-Stromdichte-Diagramm mit der Spannung U in Volt auf der horizontalen Achse und der Stromdichte J in mA/cm² auf der vertikalen Achse gezeigt. Die Spannung-Stromdichte-Kurve 58 wurde dabei mit einer Teststruktur gemäß Figur 5A gemessen. Im Vergleich hierzu ist die Spannung-Stromdichte-Kurve 59 einer Vergleichsstruktur gezeigt, die keine Metallschicht 3 aufwies. Wie aus Figur 5B leicht zu erkennen ist, kann mit der hier beschriebenen ladungserzeugenden Schicht 30 mit der Metallschicht 3 eine höhere Stromdichte bei einer gleichen Spannung im Vergleich zu einer Vergleichsstruktur ohne Metallschicht 3 erreicht werden.

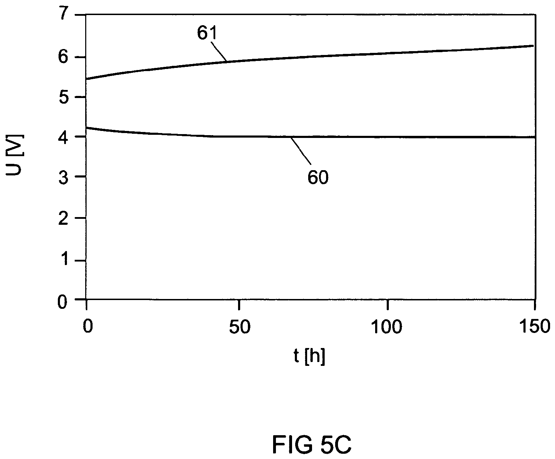

In Figur 5C ist die Betriebsspannung einer Teststruktur gemäß Figur 5A in einem Zeitraum von 150 Stunden mittels der Kurve 60 gezeigt. Im Vergleich dazu wurde, wie mittels der Kurve 61 gezeigt ist, für eine Vergleichsstruktur ohne Metallschicht 3 ein Anstieg der Betriebsspannung im gleichen Zeitraum gemessen. Während also mit einer Teststruktur gemäß Figur 5A mit der Metallschicht 3 eine stabile ladungserzeugende Schicht 30 während der Testbetriebsdauer von 150 Stunden erreicht wurde, wurden bei Vergleichsstrukturen ohne metallische Zwischenschicht Steigerungen der Betriebsspannung um über 1 V gemessen. Die mittels der Teststruktur aus Figur 5A gewonnenen Erkenntnisse sind zumindest qualitativ direkt auf die in Verbindung mit den Figuren 1 bis 4 gezeigten organischen elektrolumineszierenden Bauelemente übertragbar.

In den Figuren 2 bis 4 sind weitere organische elektrolumineszierende Bauelemente gezeigt, die Modifikationen des in Figur 1 gezeigten Ausführungsbeispiels darstellen.

Das organische elektrolumineszierende Bauelement gemäß dem Ausführungsbeispiel in Figur 2 weist einen ersten organischen Funktionsstapel 1, darüber eine Metallschicht 3 und über dieser einen zweiten organischen Funktionsstapel 2 auf einem Substrat 4 zwischen einer ersten Elektrode 5 und einer zweiten Elektrode 6 auf. Wie im Ausführungsbeispiel gemäß Figur 1 weist der erste organische Funktionsstapel 1 eine n-dotierte organische Schicht 12 und der zweite organische Funktionsstapel 2 eine p-dotierte organische Schicht 23, jeweils direkt angrenzend an die Metallschicht 3, auf, wodurch eine ladungserzeugende Schicht 30 gebildet wird.

Das Substrat 4 ist im gezeigten Ausführungsbeispiel aus Glas oder einer Kunststofffolie. Die Kunststofffolie kann weiterhin beispielsweise Polyolefine, etwa Polyethylen (PE) mit hoher oder niedriger Dichte oder Polypropylen (PP) aufweisen oder daraus gebildet sein. Weiterhin kann der Kunststoff Polyvinylchlorid (PVC), Polystyrol (PS), Polyester und/oder Polycarbonat (PC), Polyethylenterephthalat (PT), Polyethersulfon (PES) und/oder Polyethylennaphthalat (PEN) aufweisen oder daraus gebildet sein.

Die erste Elektrode 5 ist im gezeigten Ausführungsbeispiel als transparente Anode ausgebildet, auf der erste organische Funktionsstapel 1 angeordnet ist, und weist einen dünnen Metallfilm oder ein transparentes leitendes Oxid, beispielsweise Indium-Zinn-Oxid, Indium-Zink-Oxid oder Zinkoxid auf.

Der erste organische Funktionsstapel 1 weist im gezeigten Ausführungsbeispiel von der ersten Elektrode 5 aus gesehen eine p-dotierte organische Schicht 13, die als Lochtransportschicht ausgebildet ist, darüber eine Elektronenblockierschicht 14, darüber die erste elektrolumineszierende Schicht 11, die alternativ zum gezeigten Ausführungsbeispiel auch eine Mehrzahl von elektrolumineszierenden Schichten aufweisen kann, über dieser eine Lochblockierschicht 15 und über dieser die vorab beschriebene n-dotierte organische Schicht 12 auf, die im gezeigten Ausführungsbeispiel als Elektronentransportschicht ausgebildet ist.

Der zweite organische Funktionsstapel 2 weist einen ähnlichen Aufbau auf, der die oben beschriebene p-dotierte organische Schicht 23 in Form einer Lochtransportschicht, eine Elektronenblockierschicht 24, eine zweite elektrolumineszierende Schicht 21, die alternativ zum gezeigten Ausführungsbeispiel auch mehrere elektrolumineszierende Schichten umfassen kann, darüber eine Lochblockierschicht 25 und über dieser eine n-dotierte organische Schicht 22 aufweist, die als Elektronentransportschicht ausgebildet ist. Die elektrolumineszierenden Schichten 11 und 21 können gleiches oder unterschiedliches Licht erzeugen, je nachdem, was für ein Leuchteindruck auf den beiden Seiten des organischen elektrolumineszierenden Bauelements, also auf der Seite mit dem Substrat 4 und auf der Seite mit der zweiten Elektrode 6, gewünscht sind.

Im gezeigten Ausführungsbeispiel ist die Metallschicht 3 nicht-transparent und reflektierend ausgebildet. Die Metallschicht 3 weist dazu Aluminium und/oder Silber auf oder ist daraus. Im Falle von Silber weist die Metallschicht eine Dicke von größer oder gleich 40 nm und bevorzugt von größer oder gleich 50 nm auf. Im Fall von Aluminium weist die Metallschicht 3 eine Dicke von größer oder gleich 20 nm auf. Besonders bevorzugt weist die Metallschicht 3 eine Dicke von kleiner oder gleich 200 nm auf.

Die zweite Elektrode 6, die auf der dem Substrat 4 abgewandten Seite der Metallschicht 3 über dem zweiten organischen Funktionsstapel 2 angeordnet ist, ist ebenfalls als transparente Elektrode ausgebildet, die zumindest teilweise transparent für das im zweiten organischen Funktionsstapel 2 erzeugte Licht ist. Weiterhin ist die zweite Elektrode 6 im gezeigten Ausführungsbeispiel als Kathode ausgebildet und weist einen dünnen Metallfilm oder ein transparentes leitendes Oxid, wie beispielsweise in Verbindung mit der ersten Elektrode 5 beschrieben ist, auf. Alternativ zum gezeigten Ausführungsbeispiel können die erste Elektrode 5 und/oder die zweite Elektrode 6 auch mehrschichtig ausgebildet sein und beispielsweise eine oder mehrere TCO-Schichten und/oder eine oder mehrere Metallschichten und/oder eines oder mehrere der weiteren im allgemeinen Teil genannten Materialien aufweisen oder daraus sein.

Durch die nicht-transparente Metallschicht 3 zwischen dem ersten und dem zweiten organischen Funktionsstapel 1 und 2 kann das in Figur 2 gezeigte organische elektrolumineszierende Bauelement unabhängig voneinander Licht durch das Substrat 4 und die erste Elektrode 5 sowie durch die zweite Elektrode 6 abstrahlen und ist damit als so genannte bidirektional abstrahlende OLED ausgebildet.

Weiterhin kann das organische elektrolumineszierende Bauelement wie im Ausführungsbeispiel gezeigt Verkapselungsschichten 7 aufweisen, wobei die organischen Funktionsstapel 1 und 2 und die Metallschicht 3 zwischen einer auf der zweiten Elektrode 6 angeordneten Verkapselungsschicht 7 und dem Substrat 4 angeordnet sind. Zur Erhöhung der Dichtigkeit des Substrats 4 ist zwischen dem Substrat 4 und der ersten Elektrode 5 eine weitere Verkapselungsschicht 7 angeordnet.

Die Verkapselungsschichten 7 sind im gezeigten Ausführungsbeispiel transparent und sind als so genannte Dünnfilmverkapselung ausgebildet. Diese werden durch eine oder mehrere durch ein Abscheideverfahren, beispielsweise ein Atomlagenabscheideverfahren ("atomic layer deposition", ALD), hergestellt und weisen eine oder mehrere Schichten aus einem oder mehreren der im allgemeinen Teil genannten Materialien auf.

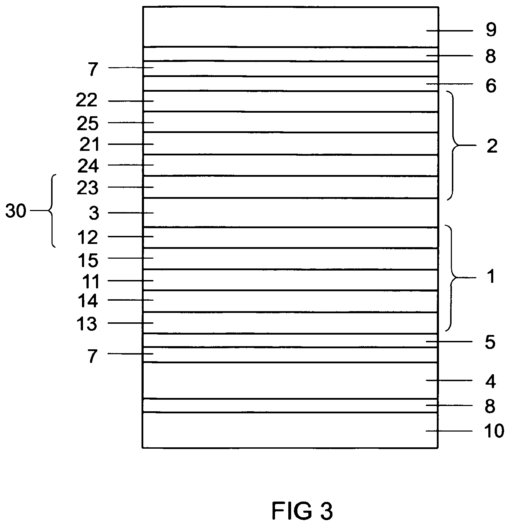

Über der zweiten Elektrode 6 und der darüber angeordneten Verkapselungsschicht 7 ist mittels einer Klebeschicht 8 eine Deckschicht 9 angeordnet, die beispielsweise aus einem Glas oder einer Kunststofffolie aus einem der vorab genannten Kunststoffmaterialien ist. Die Deckschicht 9 dient dabei insbesondere als Kratzschutz und muss aufgrund der Verkapselungsschicht 7 auf der zweiten Elektrode 6 nicht hermetisch dicht ausgeführt sein. Über der Deckschicht 9 und auf der den organischen Funktionsstapeln 1 und 2 abgewandten Seite des Substrats 4 ist jeweils mittels einer weiteren Klebeschicht 8 ein Lichtauskoppelelement 10 in Form einer Streufolie, eines Mikro-Linsen-Arrays oder einer Schicht mit einer Oberflächenstrukturierung angeordnet. Alternativ dazu können auch das Substrat 4 und/oder die Deckschicht 9 mit einer Oberflächenstrukturierung als Lichtauskoppelelement 10 versehen sein. In Figur 3 ist im Vergleich zum Ausführungsbeispiel der Figur 2 ein organisches elektrolumineszierendes Bauelement gezeigt, das nicht zur Erfindung gehört, und eine Metallschicht 3 aufweist, die teilweise transparent und teilweise reflektierend ist. Weiterhin ist in diesem alternativen Beispiel die zweite Elektrode 6 als reflektierende Metallschicht ausgeführt. Dadurch bildet, wie im allgemeinen Teil beschrieben, der zweite organische Funktionsstapel 2 eine Mikrokavität, die an den ersten organischen Funktionsstapel 1 optisch gekoppelt ist. Die Metallschicht 3 weist dazu beispielsweise Silber mit einer Dicke von größer oder gleich 10 nm und kleiner oder gleich 40 nm oder Aluminium mit einer Dicke von größer oder gleich 10 nm und kleiner oder gleich 20 nm auf.

Die durch den zweiten organischen Funktionsstapel 2 und den ersten organischen Funktionsstapel 1 gebildete gekoppelte Kavität kann durch Einstellung der Materialien der organischen Schichten 11 bis 15 und 21 bis 25 sowie deren Dicken und Anordnung zueinander optimal auf eine gewünschte Farbe ausgerichtet werden, sodass das durch das Substrat 4 abgestrahlte Licht, das eine Überlagerung des im ersten organischen Funktionsstapel 1 und im zweiten organischen Funktionsstapel 2 gebildeten Lichts ist, einen hohen Farbwiedergabeindex aufweisen kann.

Die auf der zweiten Elektrode angeordnete Verkapselungsschicht 7 kann wie im vorangegangenen Ausführungsbeispiel als Dünnfilmverkapselung ausgebildet sein. Alternativ dazu kann die Verkapselungsschicht 7 auf der zweiten Elektrode 6 beispielsweise auch als Glasschicht in Form einer Glasplatte oder eines Glassubstrats ausgebildet sein, das weiterhin auch eine Kavität oder Vertiefung, beispielsweise in Form einer geätzten Kavität, mit einem Getter-Material aufweisen kann. Im Falle eines transparenten oder als Top-Emitter ausgebildeten organischen elektrolumineszierenden Bauelements ist das Getter-Material dabei bevorzugt um den aktiven Bereich der organischen Funktionsstapel herum auf ausgebildet. Im Falle einer Glasplatte als Verkapselungsschicht 7 kann die in Figur 3 gezeigte Deckschicht 9 sowie die Klebeschicht 8 zwischen der Deckschicht 9 und der Verkapselungsschicht 7 auch entfallen.

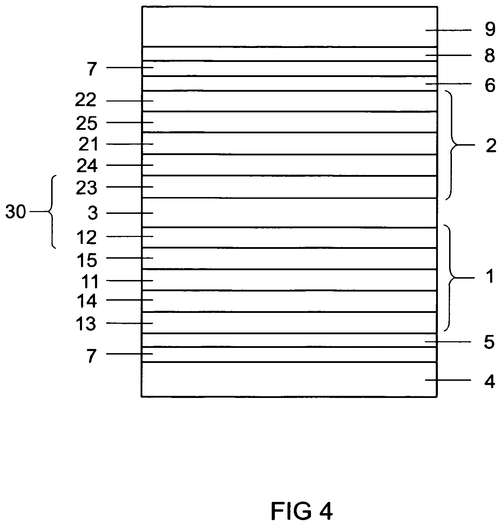

In Figur 4 ist ein weiteres alternatives Beispiel für ein organisches elektrolumineszierendes Bauelement gezeigt, das nicht zur Erfindung gehört, und im Gegensatz zu den Ausführungsbeispielen der Figuren 2 und 3 eine Metallschicht 3 aufweist, die eine Dicke von kleiner oder gleich 10 nm aufweist. Dadurch ist die Metallschicht 3 zumindest teilweise transparent. Die Elektroden 5 und 6 sind ebenfalls transparent ausgebildet, sodass die in den organischen Funktionsstapeln 1 und 2 jeweils erzeugte Strahlung beidseitig vom organischen elektrolumineszierenden Bauelement abgestrahlt werden kann. Hierbei kann je nach Transparenz der Elektroden 5 und 6 und der Metallschicht 3 auf beiden Seiten ein gleicher Farbeindruck oder auch ein leicht verschiedener Farbeindruck ermöglicht werden. Im ausgeschalteten Zustand erscheint das organische elektrolumineszierende Bauelement gemäß Figur 4 transparent. Zusätzlich können auch Lichtauskoppelelemente, wie in Verbindung mit den Figuren 2 und 3 gezeigt ist, auf einer oder beiden Seiten des organischen elektrolumineszierenden Bauelements angeordnet sein. Dadurch kann das organische elektrolumineszierende Bauelement im ausgeschalteten Zustand transluzent erscheinen.

Zusätzlich zu den gezeigten Ausführungsbeispielen der Figuren 1 und 2 und den Beispielen der Figuren 3 und 4 kann ein organisches elektrolumineszierendes Bauelement auch eine Kombination der Merkmale der gezeigten Ausführungsbeispiele und Beispiele aufweisen. So kann es beispielsweise auch möglich sein, dass ein organisches elektrolumineszierendes Bauelement zumindest drei organische Funktionsstapel aufweist, zwischen denen jeweils eine Metallschicht angeordnet ist. N-dotierte und p-dotierte Schichten zusammen mit der jeweils daran direkt angrenzenden dazwischen liegenden Metallschicht zwischen den einzelnen organischen Funktionsstapeln bilden dabei ladungserzeugende Schichten, während die einzelnen Metallschichten gleich oder unterschiedlich voneinander ausgestaltet sein können. So kann es beispielsweise möglich sein, dass ein organisches elektrolumineszierendes Bauelement eine erste Metallschicht aufweist, die nicht transparent und reflektierend ist, während eine zweite Metallschicht zumindest teilweise transparent ist. Somit kann auf einer Seite der reflektierenden, nicht-transparenten Metallschicht zumindest ein organischer Funktionsstapel angeordnet sein, während auf der anderen Seite beispielsweise zumindest zwei organische Funktionsstapel angeordnet sind. Die zwei organischen Funktionsstapel mit der dazwischen angeordneten zumindest teilweise transparenten Metallschicht können beispielsweise eine gekoppelte Mikro-Kavität, wie in Verbindung mit Figur 3 beschrieben ist, bilden.

Die Erfindung ist nicht durch die Beschreibung anhand der Ausführungsbeispiele auf diese beschränkt.

## Patentansprüche

1. Organisches elektrolumineszierendes Bauelement mit
- einem ersten organischen Funktionsstapel (1), der eine erste elektrolumineszierende Schicht (11) und zumindest eine n-dotierte organische Schicht (12) aufweist, und
- einem zweiten organischen Funktionsstapel (2), der eine zweite elektrolumineszierende Schicht (21) und zumindest eine p-dotierte organische Schicht (23) aufweist,
wobei die n-dotierte und die p-dotierte organische Schicht (12, 23) zwischen der ersten und zweiten elektrolumineszierenden Schicht (11, 21) angeordnet sind und dazwischen unmittelbar angrenzend an die n-dotierte und die p-dotierte organische Schicht (12, 23) eine Metallschicht (3) angeordnet ist,
wobei der erste und zweite organische Funktionsstapel (1, 2) zwischen einer ersten und einer zweiten Elektrode (5, 6) angeordnet ist und wobei die erste und zweite Elektrode (5, 6) transparent sind, **dadurch gekennzeichnet, dass** die Metallschicht potentialfrei, nicht kontaktierbar und nicht-transparent ist.

2. Organisches elektrolumineszierendes Bauelement nach Anspruch 1, wobei die Metallschicht (3) Aluminium und/oder Silber aufweist oder daraus ist.

3. Organisches elektrolumineszierendes Bauelement nach einem der vorherigen Ansprüche wobei die transparente erste und/oder zweite Elektrode eine Schicht mit einem transparenten leitenden Oxid und/oder eine transparente Metallschicht aufweist.

4. Organisches elektrolumineszierendes Bauelement nach einem der vorherigen Ansprüche, wobei der erste und zweite organische Funktionsstapel (1, 2) zwischen einem Substrat (4) und einer Verkapselungsschicht (7) angeordnet sind.

5. Organisches elektrolumineszierendes Bauelement nach Anspruch 4, wobei die Verkapselungsschicht (7) als Dünnfilmverkapselung ausgebildet ist.

6. Organisches elektrolumineszierendes Bauelement nach Anspruch 4 oder 5, wobei die Verkapselungsschicht (7) eine Glasschicht aufweist.

7. Organisches elektrolumineszierendes Bauelement nach einem der vorherigen Ansprüche, wobei auf einer der Metallschicht (3) abgewandten Seite der transparenten ersten und/oder zweiten Elektrode (5, 6) ein Lichtauskoppelelement (10) angeordnet ist.

## Claims

1. An organic electroluminescent component comprising
- a first organic functional stack (1), which has a first electroluminescent layer (11) and at least one n-doped organic layer (12),
- a second organic functional stack (2), which has a second electroluminescent layer (21) and at least one p-doped organic layer (23),
wherein the n-doped and p-doped organic layers (12, 23) are arranged between the first and second electroluminescent layers (11, 21), and a metal layer (3) is arranged therebetween in a manner directly adjacent to the n-doped and p-doped organic layers (12, 23),
wherein the first and second organic functional stack (1, 2) is arranged between a first and a second electrode (5, 6) and wherein the first and second electrodes (5, 6) are transparent,
**characterized in that** the metal layer is floating, not contact-connectable and non-transparent.

2. The organic electroluminescent component according to claim 1, wherein the metal layer (3) comprises aluminum and/or silver or is composed thereof.

3. The organic electroluminescent component according to any of the preceding claims, wherein the transparent first and/or second electrode (5, 6) comprises a layer with a transparent conductive oxide and/or a transparent metal layer.

4. The organic electroluminescent component according to any of the preceding claims, wherein the first and second organic functional stacks (1, 2) are arranged between a substrate (4) and an encapsulation layer (7).

5. The organic electroluminescent component according to claim 4, wherein the encapsulation layer (7) is embodied as thin-film encapsulation.

6. The organic electroluminescent component according to claim 4 or 5, wherein the encapsulation layer (7) comprises a glass layer.

7. The organic electroluminescent component according to any of the preceding claims, wherein a light coupling-out element (10) is arranged on a side of the transparent first and/or a second electrode (5, 6) that faces away from the metal layer (3).

## Revendications

1. Composant électroluminescent organique avec
- une première pile de fonctionnement organique (1), qui a une première couche électroluminescente (11) et au moins une couche organique dopée à conduction type n (12), et
- une seconde pile de fonctionnement organique (2), qui a une seconde couche électroluminescente (21) et au moins une couche organique dopée à conduction type p (23),
sachant que les couches organiques dopées à conduction type n et à conduction type p (12, 23) sont disposées entre la première et la seconde couche électroluminescente (11, 21) et qu'entre celles-ci est disposée de manière directement adjacente aux couches organiques dopées à conduction type n et à conduction type p (12, 23) une couche métallique (3),
sachant que les première et seconde piles de fonctionnement organique (1, 2) sont disposées entre une première et une seconde électrode (5, 6) et sachant que la première et la seconde électrode (5, 6) sont transparentes,
**caractérisé en ce que**
la couche métallique est sans potentiel, non susceptible d'être mise en contact et non transparente.

2. Composant électroluminescent organique selon la revendication 1, sachant que la couche métallique (3) a ou est de l'aluminium et/ou de l'argent.

3. Composant électroluminescent organique selon une quelconque des revendications précédentes, sachant que la première et/ou la seconde électrode transparentes (5, 6) a une couche avec un oxyde conducteur transparent et/ou une couche métallique transparente.

4. Composant électroluminescent organique selon une quelconque des revendications précédentes, sachant que la première et la seconde pile de fonctionnement organique (1, 2) sont disposées entre un substrat (4) et une couche d'encapsulation (7).

5. Composant électroluminescent organique selon la revendication 4, sachant que la couche d'encapsulation (7) est formée comme une encapsulation en couches minces.

6. Composant électroluminescent organique selon les revendications 4 ou 5, sachant que la couche d'encapsulation (7) a une couche de verre.

7. Composant électroluminescent organique selon une quelconque des revendications précédentes, sachant que, sur un côté de la première et/ou de la seconde électrode transparentes (5, 6) détourné de la couche métallique (3) est disposé un élément de découplage de lumière (10).
